# EUROPEAN PATENT SPECIFICATION

(11) **EP 3 993 177 B1**
(45) Date of publication and mention of the grant of the patent: **15.10.2025**
(21) Application number: 21205858.0
(22) Date of filing: 02.11.2021
(51) Int. Cl.: H01R 13/53, B60L 53/16, B60L 53/302, H05K 7/20

(54) **COOLING FLUID GUIDANCE HOUSING AND ELECTRICAL CONNECTOR SYSTEM WITH A COOLING FLUID GUIDANCE HOUSING**
KÜHLFLUIDFÜHRUNGSGEHÄUSE UND ELEKTRISCHES VERBINDERSYSTEM MIT EINEM KÜHLFLUIDFÜHRUNGSGEHÄUSE
BOÎTIER DE GUIDAGE DE FLUIDE DE REFROIDISSEMENT ET SYSTÈME DE CONNECTEUR ÉLECTRIQUE DOTÉ D'UN BOÎTIER DE GUIDAGE DE FLUIDE DE REFROIDISSEMENT

(30) Priority: 02.11.2020 DE 102020128791
(43) Date of publication of application: 04.05.2022
(73) Proprietor: TE Connectivity Germany GmbH, 64625 Bensheim (DE)
(72) Inventor: DUENKEL, Dirk, 64625 Bensheim (DE)
(74) Representative: Grünecker Patent- und Rechtsanwälte PartG mbB

(56) References cited:
- EP-A1- 3 401 955
- CN-U- 207 116 763
- CN-U- 208 737 932
- US-A1- 2019 291 588

## Description

The invention relates to a cooling fluid guidance housing for guiding a cooling fluid around an electrical connector system and to an electrical connector system comprising a connector and a mating connector and a cooling fluid guidance housing. The invention further relates to a method for installing an electrical connector system with a cooling fluid guidance housing for guiding a cooling fluid around the electrical connector system, preferably for the vehicle sector.

In the electrical field (electronics, electrical engineering, electrics, electrical power engineering, etc.) a large number of electrical connector apparatuses or devices, socket, pin and/or hybrid connectors, etc. - hereinafter referred to as (electrical) connectors (also: mating connectors) - are known which serve to transmit electrical currents, voltages, signals, and/or data having a large bandwidth of currents, voltages, frequencies, and/or data rates. In the low, medium, or high voltage and/or current range, and in particular in the vehicle sector, such connectors must ensure a rapid transmission of electrical power, signals, and/or data permanently, repeatedly, and/or after a comparatively long period of inactivity in mechanically stressed, warm, possibly hot, contaminated, humid, and/or chemically aggressive environments. Due to a wide range of applications, a large number of specially designed connectors are known.

Such a connector and possibly its associated (e.g. in the case of a connector apparatus or a connector device) or higher-level (e.g. in the case of a connector device) housing can be attached to an electric line, a cable, a cable harness, etc. - hereinafter referred to as an (electrical) preassembled cable-, or on/in an electrical device or apparatus, such as. at/in a housing, at/on a lead frame, at/on a printed circuit board, etc., a (power) electrical, electro-optical, or electronic component or a corresponding aggregation, etc. (electrical entity).

If a connector (with/without a housing) is disposed on a cable, a line or a cable harness, respectively, then this is referred to as a floating (plug) connector or a plug, a socket, or a coupling; if it is disposed on/in an electrical, electro-optical, or electronic component, aggregation, etc., then this is referred to as a connector device, such as e.g. a (panel/add-on) connector, a (panel/add-on) plug or a (panel/add-on) socket. Furthermore, a connector on such a device is often referred to as a (connector) receptacle, header socket, pin header, or header. In the context of electrical energy technology (generation, conversion, storage, transportation, and forwarding of high electrical current in electrical grids, preferably with three-phase high-voltage transmission), this is presently referred to as cable fittings due to their comparatively complex configuration.

Such a connector must ensure the flawless transmission of electricity, where corresponding and in part complementary connectors (connector and mating connector) typically comprise locking devices and/or fastening devices for permanent and typically releasable locking and/or fastening the connector on/in the mating connector or vice versa. Furthermore, an electrical connection device for a connector, e.g. having or comprising an actual contact apparatus (terminal; mostly formed materially as one part or integrally, e.g. a contact element etc.) or a contact device (terminal; mostly formed as several parts, two-part, as a single part, materially as one piece or integrally, e.g. a single-part or multi-part (crimp) contact device), must be securely received therein. In the case of a (pre) assembled electrical cable, such a connecting device can be provided as a connector (see above), i.e. without a housing, e.g. in a floating manner.

Efforts are constantly being made to improve electrical connectors and their terminals, in particular to design them more efficiently and to configure and/or manufacture them to be more inexpensive. Increasing hybridization and electrification of a drive train of a vehicle as well as increasing electrification of ancillary units entail, inter alia, thermal loads which can have negative effects, if not addressed. This relates, inter alia, to electrical plug connections in a vehicle. There is an increasing need for cooling, as is known for cable fittings from the field of electrical power engineering.

US 8,926,360 A1 discloses an electrical connection with an active cooling device, where the electrical connection comprises at least one electrical connection composed of a female and a male terminal. The at least one female terminal is optionally surrounded by heat-resistant electrical insulation and is configured in a wall of an electrical device together with a heat sink that conducts heat comparatively well. Furthermore, the female terminal comprises an opening so that heat generated in the female terminal can be dissipated from the female terminal. The heat generated between the female and a male terminal can be transported away from the heat sink and the opening of the female terminal by a fan via ambient air of the electrical connection.

Furthermore, US 9,287,646 B2 discloses an electrical connection in which an electrical connector is connected to an electrical line assembly, such as a cable. Either the electrical connector or the electrical line assembly is there actively cooled by a heat transport medium which flows substantially along the electrical line assembly and through the electrical connector.

However, the known electrical connector systems have the drawback that a coolant flows through the interior of the connector housing, leaving behind impurities, for example, as dirt particles or moisture, which can be deposited on the contact elements of the electrical connector system. This contamination can lead to corrosion and other damage to the contact elements so that the service life of the electrical connector system is reduced.

CN 207 116 763 U discloses a plug-in female terminal including a plug connector and an outer sleeve part. The outer sleeve part is equipped with coolant liquid entry and cooling liquid exit and is disposed outside one end of the plug connector. At least one partitioning rib protrudes from an outer surface of the plug connector to form a plurality of flow passages. The cooling liquid enters from the cooling liquid inlet, passes through the plurality of flow passages, and flows out of the cooling liquid outlet.

CN 208 737 932 U discloses a cooling system of a high-power DC charging connector. An inner cover is surrounded by a rear cover, which comprises a cooling joint. The cooling joint is in fluid contact with guide channels, which are formed by the inner cover and the rear cover, and through which the cooling liquid can flow.

It is therefore an object of the invention to provide cooling for an electrical connector system that overcomes the drawbacks of the known solutions, so that the connector systems produced are safe and reliable, but nevertheless can be produced inexpensively and take up little installation space.

The invention is defined in the appended independent claims. Advantageous and preferred embodiments of the present invention are defined by the dependent claims. Examples, aspects and embodiments presented in the following and not necessarily falling under the scope of the claims are provided in the application to better understand the invention.

The present disclosure is based on the idea of achieving active cooling with minimal additional space requirements by providing a separate cooling fluid guidance housing through which a cooling fluid can flow and which can be attached to an electrical connector system. The cooling fluid guidance housing conducts a cooling fluid in an advantageous manner on the exterior along an outer wall of a connector housing in the vicinity of the point of contact (hereinafter also referred to as hotspot), absorbs the heat generated in the electrical connector system by the electrical connection and transferred to the connector housing and transports it along the outer wall of the connector housing to a respective heat sink. As a result, particularly efficient heat management and consequently efficient energy transfer can be obtained.

Embodiments of the invention define a cooling fluid guidance housing according to claim 1 and a method for installing an electrical connector system according to claim 12, further embodiments are defined by the dependent claims.

According to the disclosure, the inner wall of the cooling fluid guidance housing in the second section defines at least one cooling channel which surrounds at least in part the outer wall of the connector housing, where the cooling fluid guidance housing comprises at least one cooling fluid connection by way of which the cooling fluid can be introduced into the at least one cooling channel.

In this manner, the cooling fluid guidance housing can be fixedly attached to the electrical connector with the aid of the support elements. Furthermore, the resulting cooling channel enables a cooling fluid to be guided around the outside of the connector housing so that the cooling fluid does not need to be passed through the interior of the connector housing, where this can lead to contamination and therefore to damage to the electrical lines or contact elements.

A distance between the cooling fluid guidance housing and the outer wall of the connector housing, which defines a ruling section or effective volume of the cooling channel for fluid transport, can there be selected such that the inner wall of the cooling fluid guidance housing is nestled tightly against the outer wall of the connector housing in order to increase cooling efficiency.

A preferred cooling fluid is air, but it can also be a different gas, such as e.g. nitrogen. Nitrogen can there be e.g. separated from the ambient air by a pressure swing adsorption process (PSA) on board a vehicle. The term gas is of course also to include the term gas mixture (cf. air). Alternatively, the cooling fluid can also be a coolant such as is already present in the cooling circuit of a vehicle. The cooling fluid can be e.g. a cooling fluid that is pre-cooled by an air conditioning unit or a non-pre-cooled cooling fluid that originates from a fan or a compressor and possibly a radiator.

The cooling fluid guidance housing can preferably be configured as a connection port, a connection flange, or a connection socket. The cooling fluid guidance housing can have a single, exactly two, or a plurality of cooling fluid connections, so that the cooling channel can be supplied with cooling fluid at several points. Alternatively, however, different cooling fluid connections can each supply one or more of the cooling channels with cooling fluid, so that several cooling channels separated from one another can be defined by the cooling fluid guidance housing.

In order to guide the cooling fluid along the outer wall of the connector housing as selectively as possible in the vicinity of the point of contact, the cooling fluid guidance housing comprises at least one cooling fluid guidance wall which is adapted to define part of the at least one cooling channel. Not only the point of contact to which the cooling fluid is guided is to serve as the hotspot; further hotspots along the connector housing can be defined, for example, in advance by simulations. The cooling fluid guidance walls can then define the at least one cooling channel such that the at least one cooling channel is led as efficiently as possible to these further hotspots.

According to an advantageous aspect, the cooling channel, starting out from the cooling fluid connection in the cooling fluid guidance housing, opens outwardly along the outer wall of the connector housing through a channel opening for the exit of cooling fluid, where the cooling channel, apart from the channel opening, is configured to be permeable to gas at at least one further point along the inner wall of the cooling fluid guidance housing.

The heated cooling fluid can be transported through this point that is permeable to gas away from the cooling channel in a particularly simple manner. The point of the cooling channel permeable to gas can also be formed, for example, by a further cooling fluid connection, by way of which the heated cooling fluid is transported away to a respective heat sink of a cooling circuit.

The present disclosure further relates to an electrical connector system, comprising a connector and a mating connector, with a cooling fluid guidance housing according to the present disclosure.

The (mating) connector is configured in particular as a low-voltage (mating) connector, preferably as a vehicle (mating) connector for an electrical system of a vehicle. Electrical voltages of less than 5kV are regarded as being low voltages. Accordingly, the electrical connector system can be configured for low voltages up to voltages of 1 kV to 5 kV with, possibly short-term, currents of up to 500A.

This means in particular that the connector has no external shielding (electrically conductive layer, protective cover, etc.) on its connector housing for the removal of surface charges, for field distribution, for electromagnetic shielding, etc. This means that the connector housing is in particular electrically non-conductive on the outside. There is preferably no specially configured Faraday cage inside the connector housing; apart from applications for shielded coaxial cables or twisted pair cables which exhibit such due to their particular structure, but do not comprise it separately as is the case with cable fittings.

Furthermore, the electrical connector system comprises in particular no field control member, no grounding device, no capacitive divider, no capacitive test point, no sealing plug, no protection for e.g. an underground, in particular buried, place of use, no UV protection, and/or no seizure protection. Furthermore, a contact element of the connector is preferably without a thread. A vehicle can be understood to be a land vehicle (road vehicle, off-road vehicle, and/or rail vehicle), a watercraft (displacer and/or glider), and/or an aircraft (propeller-driven aircraft, jet aircraft, helicopter, and/or airship).

In a preferred aspect, the at least one cooling channel is led along the outer wall of the connector housing such that the at least one cooling channel can be led in the direction of a heat source within the connector housing. The heat source can be the point of contact in the electrical connector system or any other hotspots determined by simulation outcomes that arise when current flows through the electrical connector system.

The cooling fluid guidance housing advantageously comprises at least one second cooling fluid connection for transporting the cooling fluid away downstream. In this way, the heated cooling fluid can be transported away particularly easily to a corresponding heat sink of a cooling circuit. The cooling fluid, which has cooled down again, can subsequently be fed back into the interior of the cooling fluid guidance housing.

According to a further advantageous aspect, the predefined distance in the second section between the inner wall of the cooling fluid guidance housing and the outer wall of the connector housing differs in an inlet section from that of an outlet section of the at least one cooling channel.

In this manner, a ruling section or effective volume of the cooling channel for fluid transportation in an inlet section of the cooling channel (e.g. cooling fluid connection or an adjoining downstream section of the cooling channel) can differ from that of an outlet section of the cooling channel (e.g. cooling fluid connection or an opening in the cooling fluid guidance housing that is permeable to gas or an adjoining upstream section of the cooling channel). It is there preferred to have the ruling section or the effective volume in the inlet section of the cooling channel be smaller than in a e.g. comparable section disposed downstream thereof in the outlet section of the cooling channel.

The cooling fluid guidance housing in the direction of a contact element access for the mating connector can advantageously terminate flush with the outer wall of the connector housing. The termination of the cooling fluid guidance housing and the outer wall of the connector housing can be configured in a sealed manner. In this way, the cooling channel in the cooling fluid guidance housing is led away from a terminal access for the mating connector. This prevents cooling fluid that has been heated by the hotspot(s) in the connector housing from escaping in the direction of the mating connector, thereby heating the latter.

According to a further advantageous aspect, the cooling fluid guidance housing can also be adapted to receive the mating connector, where the cooling fluid guidance housing comprises a third section in which the inner wall of the cooling fluid guidance housing is adapted such that the inner wall in the third section follows an outer wall of a mating connector housing of the mating connector at a predefined distance, where the inner wall of the cooling fluid guidance housing in the third section defines the at least one cooling channel which surrounds at least in part the outer wall of the mating connector housing.

In this way, the mating connector housing can also be cooled in addition to the connector housing, so that cooling efficiency can be further increased. The cooling channel then surrounds at least in part the outer wall of the connector housing, as well as the outer wall of the mating connector housing.

In order to ensure the simplest possible attachment of the cooling fluid guidance housing to the electrical connector or the electrical plug connection, the cooling fluid guidance housing comprises a plurality of cooling shells, where each of the cooling shells comprises fastening elements with the aid of which the respective cooling shell can be fastened to at least one of the other cooling shells.

In a non-claimed example, the cooling fluid guidance housing can of course also be formed integrally or materially integrally. The at least one cooling fluid connection can also be an integral component of the cooling fluid guidance housing. It is then possible to manufacture the cooling fluid guidance housing from a single original piece (e.g. a blank) or from a single original mass (e.g. plastic melt). The cooling fluid guidance housing can advantageously be configured such that the inner wall of the cooling fluid guidance housing in the second section and the outer wall of the connector housing each form a plurality of separate cooling channels. This configuration is particularly advantageous if the connector housing has a modular structure and comprises a plurality of connector modules, in each of which an electrical terminal can be formed or is formed. In this case it is possible that only the cooling channels that are associated with an inserted connector module are supplied with cooling fluid, while other cooling channels are closed, for example, by blind plugs or blind flanges. The efficiency of the cooling can thus be further increased, while it is possible at the same time to manufacture standardized cooling fluid guidance housings.

In order to guide the cooling fluid efficiently to the heat sources in the electrical connector system, the outer wall of the connector and/or of the mating connector can comprise at least one fluid guidance element that defines the at least one cooling channel. The fluid guidance element can be complementary to additional cooling fluid guidance walls of the cooling fluid guidance housing which are also adapted to guide the cooling fluid along the outer wall of the connector housing.

The present disclosure further relates to a method for installing an electrical connector system with a cooling fluid guidance housing for guiding a cooling fluid around the electrical connector system, the method comprising the following steps:
providing the electrical connector system comprising a connector and a mating connector,
attaching the cooling fluid guidance housing, where
   the cooling fluid guidance housing is made to contact a connector housing of the connector in a first section in which at least one support element is arranged,
   an inner wall of the cooling fluid guidance housing in a second section follows an outer wall of the connector housing at a predefined distance, where the inner wall of the cooling fluid guidance housing in the second section defines at least one cooling channel which surrounds at least in part the outer wall of the connector housing, and
   the cooling fluid guidance housing comprises at least one external cooling fluid connection by way of which the cooling fluid can be introduced into the at least one cooling channel.

The active cooling according to the present disclosure can advantageously also be extended to the mating connector. The method then additionally comprises that the cooling fluid guidance housing is attached in such a manner that the inner wall of the cooling fluid guidance housing in a third section follows an outer wall of a mating connector housing of the mating connector at a predefined distance, where the inner wall of the cooling fluid guidance housing in the third section defines the at least one cooling channel which surrounds at least in part the outer wall of the mating connector housing.

For a better understanding of the present disclosure, it shall be explained in more detail with reference to the embodiments shown in the following figures. Same parts are provided with the same reference numerals and the same component names.
- Fig. 1: shows a schematic perspective illustration of the electrical connector system according to a first example;
- Fig. 2: shows a further schematic perspective illustration of the electrical connector system according to the first example;
- Fig. 3: shows a further schematic perspective illustration of the electrical connector system according to the first example;
- Fig. 4: shows a schematic exploded illustration of the electrical connector system according to the first example;
- Fig. 5: shows a schematic perspective illustration of a cooling shell of a cooling fluid guidance housing;
- Fig. 6: shows a schematic sectional illustration of the electrical connector system according to the first example;
- Fig. 7: shows a schematic exploded illustration of the electrical connector system according to a second example;
- Fig. 8: shows a further schematic exploded illustration of the electrical connector system according to the second example;
- Fig. 9: shows a schematic sectional illustration of the electrical connector system according to the second example.

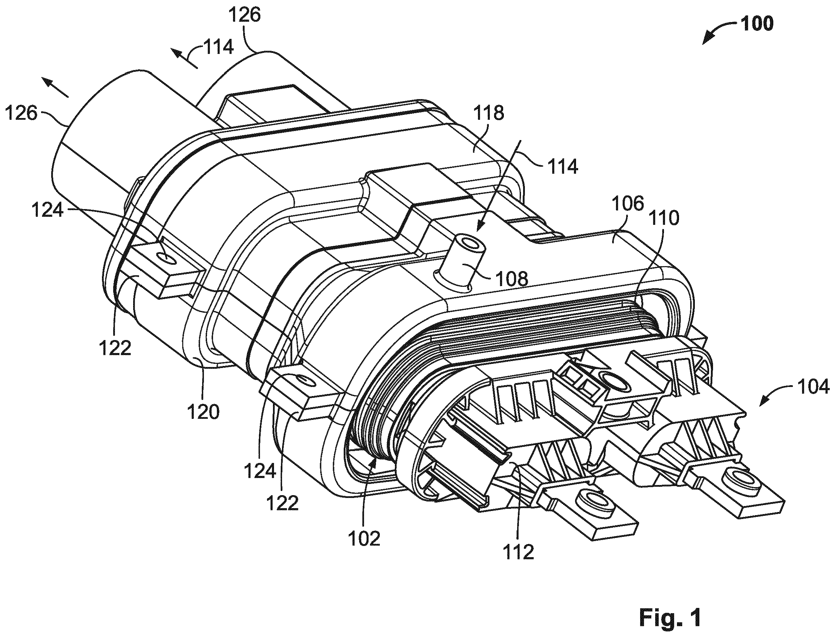

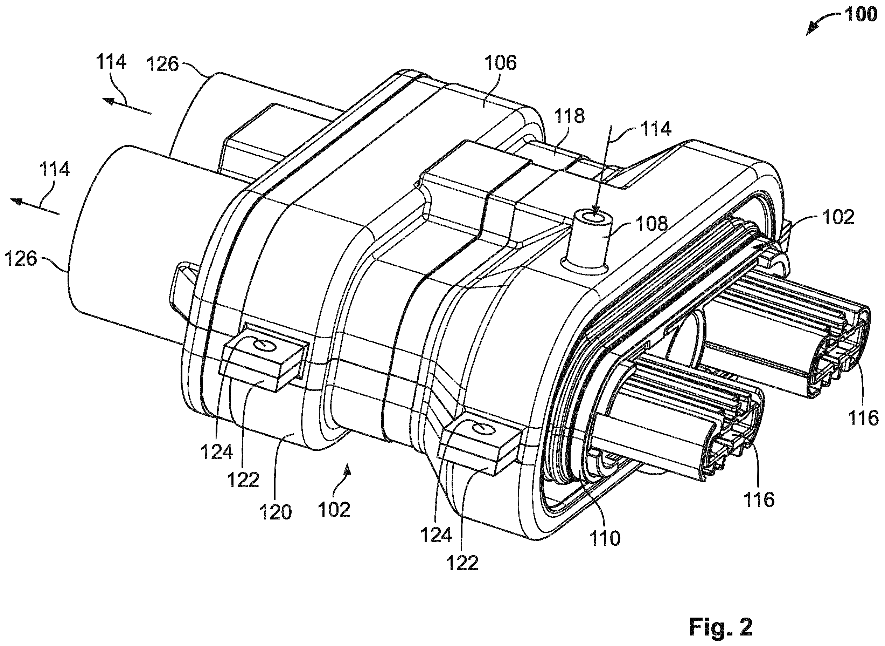

The present invention shall be explained in more detail hereafter with reference to the figures, and in particular first with reference to the schematic perspective illustration of Figures 1 and 2. It is noted that the size ratios in all of the figures and in particular the layer thickness ratios are not necessarily shown true to scale. Furthermore, parts that are not necessary or obstructive for the understanding are not shown. Designations such as connector and mating connector, terminal and mating terminal etc. are to be interpreted synonymously, i.e., possibly interchangeable with each other.

Figure 1 shows a schematic perspective illustration of two (electrical) connectors 102 and 104 of an electrical connector system 100 according to a first advantageous embodiment of the present invention that are plugged into one another. Electrical connector 102 is there configured as a preferably floating socket connector 102, while connector 104, hereinafter referred to as mating connector 104, is presently configured as a connector receptacle 104, a header socket 104, pin header 104, or header 104. Connector 102 can there be part of an assembled electrical cable or an electrical entity.

Electrical connector 102 comprises a connector housing 110 in which at least one electrical contact element (not shown) is formed or can be formed. Electrical mating connector 104 likewise comprises a mating connector housing 112 in which at least one electrical contact element (not shown) is formed or can be formed. Connector housing 110 and mating connector housing 112 are each manufactured from insulating material such as a plastic material.

By plugging connector housing 110 into mating connector housing 112, the at least one contact element can be made to conductively contact the at least one mating contact element at a point of contact, so that an electrical current can flow through the electrical connector system 100.

Figure 2 shows a schematic perspective illustration of connector 102 which is surrounded by cooling fluid guidance housing 106. Electrical mating connector 104 is not shown in this figure. This makes contact element receiving chambers 116 visible, through which connector 102 can receive contact elements of mating connector 104.

For cooling electrical connector system 100 by dissipating heat that is generated when current is transported through electrical connector system 100, connector housing 110 is in large parts surrounded by a cooling fluid guidance housing 106, as shown in the example in Figures 1 and 2. Cooling fluid guidance housing 106 is adapted to guide a cooling fluid 114, preferably air, at least in part around the outside of connector housing 110 in order to transport away heat that is generated in the interior of connector housing 110. For this purpose, the cooling fluid guidance housing comprises a cooling section (second section) in which a cooling channel is defined by an inner wall of the cooling fluid guidance housing and thus forces a cooling fluid 114 introduced into the cooling channel in the cooling section to flow around the outer wall of connector housing 110. The cooling section is there not necessarily contiguous, but can consist of a plurality of subsections, each of which, for example, defines a separate cooling channel.

As further shown in Figures 1 and 2, the cooling fluid guidance housing can comprise an upper shell 118 and a lower shell 120 which can be connected to one another by fastening elements 122. In this way, simple assembly of cooling fluid guidance housing 106 to the electrical connector system 100 can be ensured. However, a two-part design of the cooling fluid guidance housing is not essential for the present invention. The cooling fluid guidance housing can alternatively also be formed as a single part (or integrally) or to be assembled from a plurality of individual shells.

Fastening elements 122 are shown there by way of example as projections in which hole-shaped recesses 124 can be provided with the aid of which upper shell 118 and lower shell 120 can be fastened to one another using rivets or screws. Alternatively, fastening elements 122 can also have latching devices with the aid of which upper shell 118 and lower shell 120 can be firmly connected to one another. Furthermore, upper shell 118 and lower shell 120 can also be adhesively bonded to one another.

In order to be able to attach cooling fluid guidance housing 106 in a stable manner to electrical connector system 100, the cooling fluid guidance housing has support elements (shown later) which are made to contact connector housing 110, mating connector housing 112 or both, and support cooling fluid guidance housing 106.

In order to introduce cooling fluid 114 into cooling fluid guidance housing 106, cooling fluid guidance housing 106 comprises a cooling fluid connection 108 which is preferably configured as a connection port 108, so that a hose-like cooling fluid supply line can simply be pushed or plugged onto respective connection port 108 and possibly be further affixed there (not shown). It is of course possible to select a different fluid connection instead of a connection port 108, such as, e.g. a connection flange, a connection socket, etc. Gas seals can be used in all embodiments.

Starting out from an inlet opening in the region of cooling fluid connection 108, the cooling fluid introduced can flow along the outer wall of connector housing 110 until the cooling fluid can again leave the interior of cooling fluid guidance housing 106 at an outlet opening 126. As presently shown, the outlet openings can be formed, for example, by openings in the region of the connections of an electrical cable or an electrical device, such as, for example, an electrical unit. Outlet openings 126 can of course also be provided in other regions of cooling fluid guidance housing 106. In particular, the transitions between upper shell 118 and lower shell 120 can be configured to be permeable to fluid so that these transitions offer additional venting options for the heated cooling fluid in the interior of cooling fluid guidance housing 106.

But the transitions between upper shell 118 and lower shell 120 can alternatively also comprise a seal which prevents the cooling fluid from escaping at these transitions.

Furthermore, cooling fluid guidance housing 106 can comprise at least one additional cooling fluid connection which can serve as an alternative outlet opening in order to enable the heated cooling fluid to be transported away downstream.

As shall be described below, the inlet opening in the region of cooling fluid connection 108 and outlet opening 126 are connected by a cooling channel which surrounds at least part of the outer wall of connector housing 110. The cooling channel is defined on one side by at least part of the outer wall of connector housing 110 and on the other side at least by the inner wall of cooling fluid guidance housing 106, which together form the cooling channel. A ruling section or an effective volume of the cooling channel for fluid transport can therefore be determined largely by the distance between the outer wall of connector housing 110 and the inner wall of cooling fluid guidance housing 106.

Cooling fluid guidance housing 106 can be manufactured from electrically conductive material, such as, for example, aluminum, for dissipating the heat absorbed by the cooling fluid as efficiently as possible to the environment. Alternatively, cooling fluid guidance housing 106 can also be manufactured from plastic material such as silicone, polytetrafluoroethylene (PTFE), polyethylene (PE), or polypropylene (PP) in order to keep the weight caused by cooling fluid guidance housing 106 as low as possible.

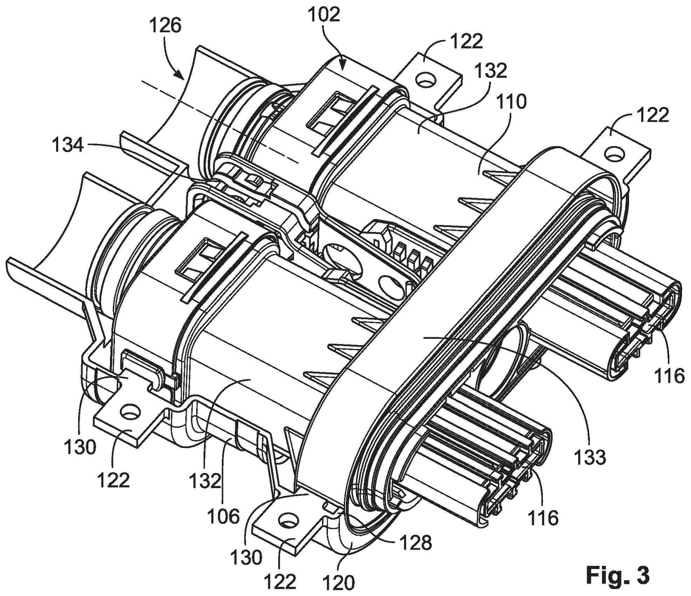

Figure 3 shows a schematic perspective illustration of the electrical connector system according to the first example without mating connector 104 and without upper shell 118 of cooling fluid guidance housing 106. As a result, in particular support elements 130 are visible in Figure 3 and are made to contact connector housing 110 and thereby stabilize cooling fluid guidance housing 106 on connector housing 110. Support elements 130 are arranged in a first section of cooling fluid guidance housing 106 which serves as a support section. As can be seen in the figure, this support section is not necessarily contiguous, but can comprise a plurality of smaller support sections. Support elements 130 can advantageously be attached in the vicinity of fastening elements 122 so that a force transmission path between fastening elements 122 and support elements 130 can be kept short.

Furthermore, an outer edge 128 of cooling fluid guidance housing 106 can be made to contact connector housing 110 in order to increase the stability of the attachment of the cooling fluid guidance housing. In particular, outer edge 128 of cooling fluid guidance housing 106 can terminate flush with connector housing 110 so that connector housing 110 can be prevented from protruding in this region. It can be prevented by a termination that is as tight as possible between outer edge 128 and connector housing 110 in the direction of contact element receiving chambers 116 that heated cooling fluid can escape from the cooling fluid guidance housing in the direction of a mating connector 104 and heat the latter.

As can be seen in the embodiment shown, connector housing 110 can have a modular structure, meaning that it can comprise several connector modules 132 that can be plugged together, where at least one contact element is formed or can be formed in each of the connector modules 132 that can be plugged together. Each of connector modules 132 can then, for example, be pushed into a holding element 133 and connected to one another with a connecting element 134, such as a clamp.

In this case, cooling fluid guidance housing 106 can comprise a separate cooling channel for each of connector modules 132. An associated cooling fluid connection 108 can be provided for each of the separate cooling channels so that each of connector modules 132 can be cooled as required by the cooling fluid flowing through the respective separate cooling channel. In addition, cavities which accommodate holding element 133 and connecting elements 134 can be provided in cooling fluid guidance housing 106.

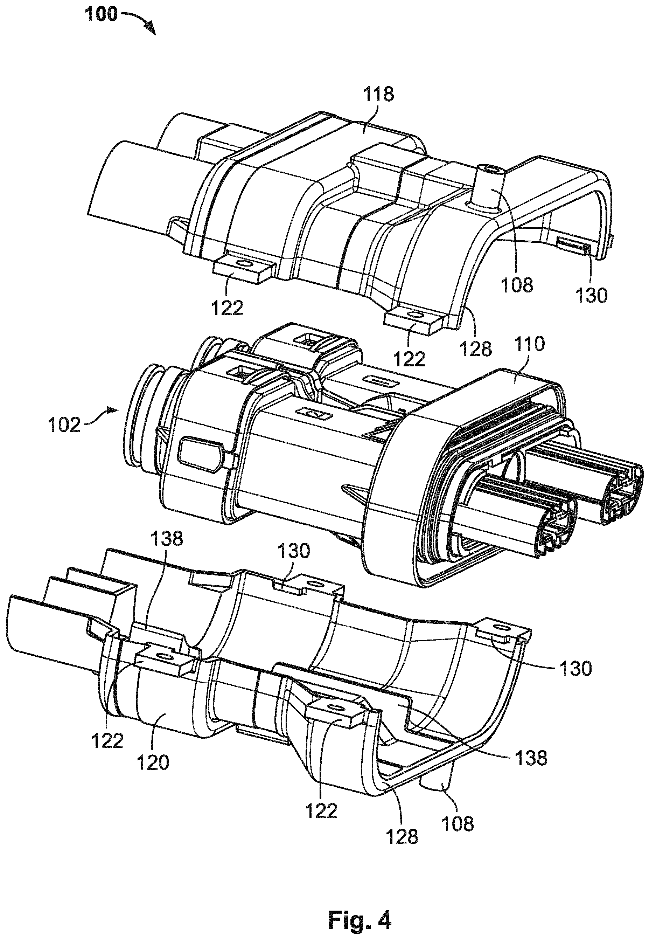

Figure 4 shows a schematic exploded illustration of electrical connector system 100 according to the first example without mating connector 104. As is clear from this view, connector housing 110 can be inserted between upper shell 118 and lower shell 120 for mounting the assembly, where outer edge 128 of cooling fluid guidance housing 106 and support elements 130 are made to contact connector housing 110. Upper shell 118 and lower shell 120 can then be fastened to one another in a closed manner with the aid of fastening elements 122. Cooling fluid guidance housing 106 can then be attached to connector 102 either before or after the closure of electrical connector system 100.

As is also shown in Figure 4, upper shell 118 and lower shell 120 each comprise a cooling fluid connection 108 which can supply either a common cooling channel or two separate cooling channels within the cooling fluid guidance housing. Alternatively, one of two cooling fluid connections 108 can serve as an upstream cooling fluid inlet, while the other of cooling fluid connections 108 serves as a downstream cooling fluid outlet.

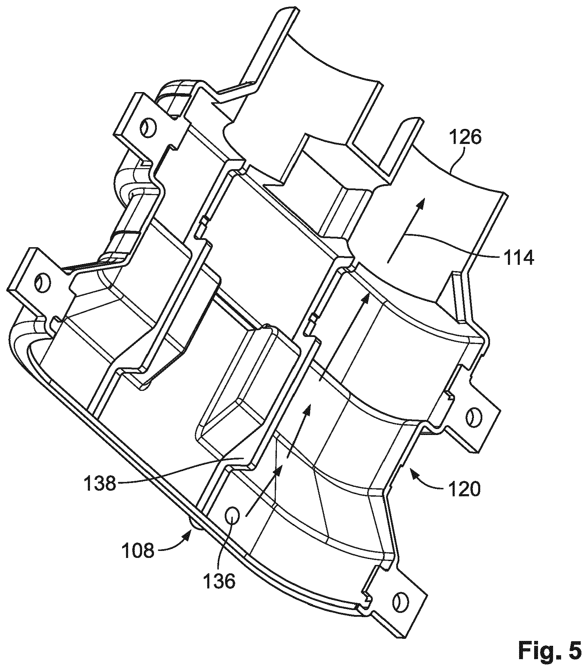

Figure 5 shows a schematic perspective illustration of a lower shell 120 of cooling fluid guidance housing 106. As shown schematically in Figure 5 by arrows 114, the cooling channel opens in the interior of cooling fluid guidance housing 106, starting out from inlet opening 136 in the region of cooling fluid connection 108 along the inner wall of lower shell 120 of cooling fluid guidance housing 106. The cooling channel is there defined by the inner wall of lower shell 120 and the outer wall of connector housing 110, so that cooling fluid 114 flows along the outer wall of connector housing 110 through the cooling channel to outlet opening 126. The inner wall of lower shell 120 is advantageously shaped such that it follows the shape of the outer wall of connector housing 110.

Cooling fluid guidance walls 138, which additionally guide the flow of fluid within cooling fluid guidance housing 106, can be attached to lower shell 120 of cooling fluid guidance housing 106. Cooling fluid guidance walls 138 can there be formed integrally with cooling fluid guidance housing 106. Cooling fluid guidance walls 138 serve, firstly, to guide cooling fluid 114 as efficiently as possible in the direction of heat sources or hotspots that arise within connector housing 110. Secondly, cooling fluid guidance walls 138 can also serve as partition walls which separate several individual cooling channels from one another. The individual cooling channels can be symmetrically shaped, but can also have different configurations, for example, a distance between the inner wall of cooling fluid guidance housing 106 and the outer wall of connector housing 110 can vary among the different cooling channels.

A configuration of upper shell 118 can be effected in analogy to the configuration of lower shell 120.

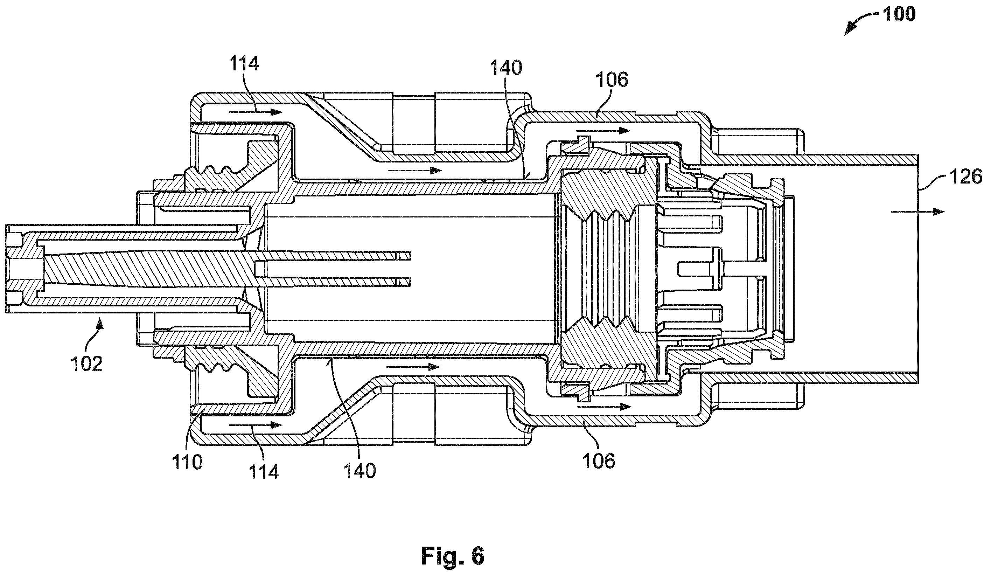

Figure 6 shows a schematic sectional illustration of connector 102 which is surrounded by the cooling fluid guidance housing. As shown schematically in the figure by arrows, cooling fluid 114 can flow through a cooling fluid connection 108 (not shown) into a cooling channel which is defined by the inner wall of cooling fluid guidance housing 106. The cooling fluid there flows along an outer wall 140 of connector housing 110 so that one or more heat sources within the connector housing can be cooled by the heat being transported away. Where the heat is transported from a heat source out from the interior of connector 102 first through connector housing 110 to outer wall 140 of connector housing 110, around which cooling fluid 114 flows on the outside. The cooling fluid there cools outer wall 140 of connector housing 110 and therefore indirectly also the heat source within connector 102 and thereby absorbs the heat transported through connector housing 110.

The heated cooling fluid can then exit the cooling channel through outlet opening 126 and be transported away from the cooling fluid guidance housing. Even if the predominant direction of flow is presently shown in the axial direction in the direction of outlet opening 126, cooling fluid 114 can certainly also flow around the outer wall in the radial direction. Air guide walls, which can be attached both to the inner wall of cooling fluid guidance housing 106 as well as optionally to the outer wall of connector housing 110, can therefore extend both in the axial direction as well as in the radial direction around connector housing 110.

As illustrated using Figure 6, a ruling section or an effective volume of the cooling channel for fluid transport can be determined largely by the distance between outer wall 140 of connector housing 110 and the inner wall of cooling fluid guidance housing 106. It is therefore advantageous to have the distance between outer wall 140 of connector housing 110 and the inner wall of cooling fluid guidance housing 106 be reduced in a region in which cooling fluid 114 flows around connector housing 110 around a heat source ("hotspot") in order to increase the flow rate and therefore the efficiency of cooling the cooling fluid in the region of the hotspot. As mentioned above, such a heat source can arise, for example, in the region of the point of contact when current flows through the contact elements of the connector and the mating connector.

Even if only one embodiment has been shown so far in which cooling fluid guidance housing 106 surrounds at least in part connector 102, cooling fluid guidance housing 106 can of course also surround at least in part mating connector 104 so that a cooling fluid for cooling can flow through cooling fluid guidance housing 106 at the outside around mating connector housing 110. Furthermore, connector 102 as well as mating connector 104 can each be equipped with a separate cooling fluid guidance housing. Once both connectors 102 and 104 have been plugged into one another, the two separate cooling fluid duct housings can there each form a common higher-level cooling fluid guidance housing with shared cooling channels, so that connectors 102 and 104 can be cooled together. Alternatively, the cooling channels formed in two separate cooling fluid guidance housings 106 can also remain separated from one another after both two connectors 102 and 104 have been plugged into one another so that each of connectors 102 and 104 is cooled separately.

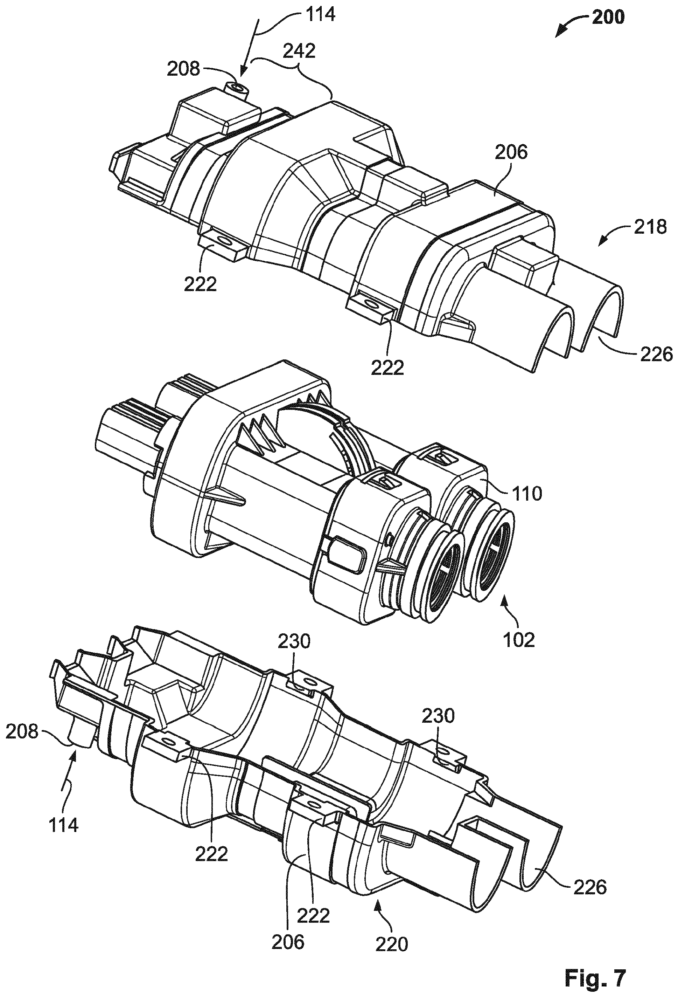

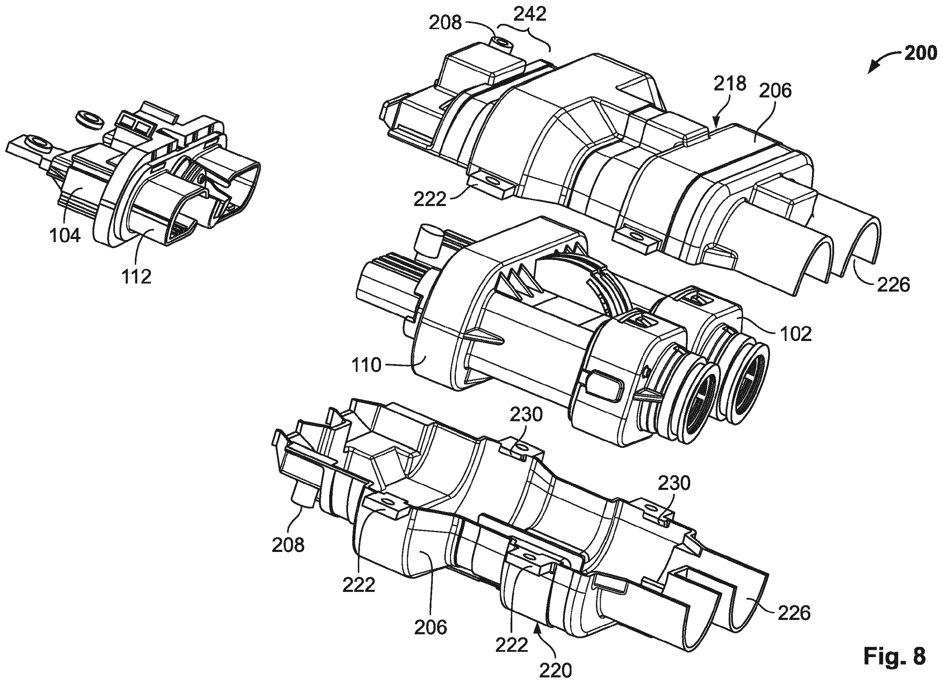

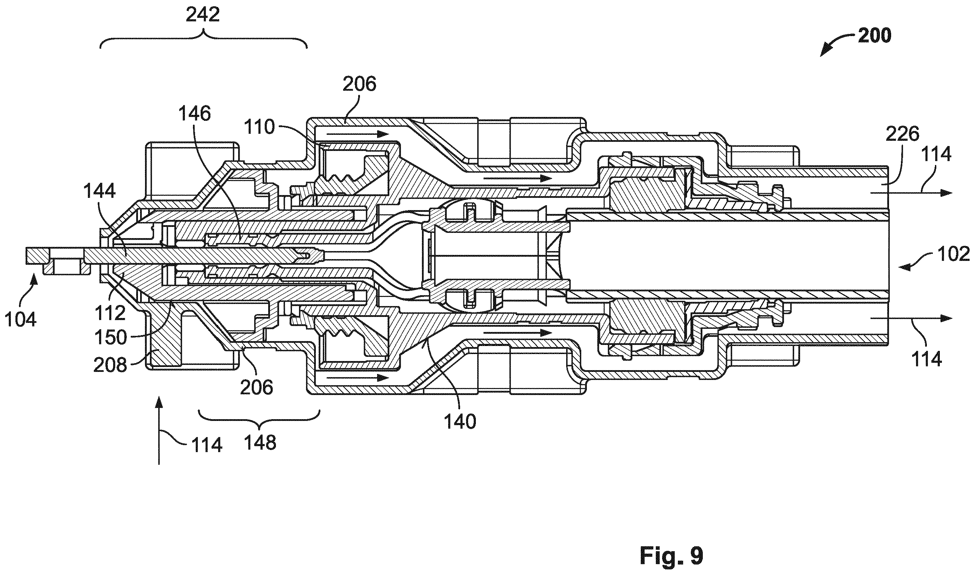

Figures 7 and 8 each show a schematic exploded illustration of electrical connector system 200 according to a second advantageous embodiment. Where Figure 7 shows electrical connector system 200 without mating connector 204 and Figure 8 shows electrical connector system 200 with mating connector 204. Figure 9 shows a corresponding schematic sectional illustration through electrical connector system 200 according to the second embodiment.

Of course, all aspects and advantages that were described for the first embodiment also apply to the second embodiment. The second embodiment differs from the first embodiment only in that cooling fluid guidance housing 206 comprises a receiving section 242 (third section) in which the cooling fluid guidance housing can receive mating connector 104.

After reception of mating connector 104, cooling fluid guidance housing 206, formed by an upper shell 218 and a lower shell 220 in Figures 7 and 8 by way of example, defines a cooling channel which surrounds at least in part an outer wall of mating connector housing 112. This cooling channel can be in fluid communication with the cooling channel which surrounds the outer wall of connector housing 110. Both cooling channels, however, can also be formed separately in embodiments.

A cooling fluid connection 208 can then be attached to cooling fluid guidance housing 206, for example, in the region of receiving section 242 so that cooling fluid 114 first flows around the outer wall of mating connector housing 112 after entering the cooling fluid guidance housing. Cooling fluid 114 is then guided through the cooling channel on the outside along the outer wall of connector housing 110 until it can exit cooling fluid guidance housing 206 again at one or more outlet openings 226 and can transport away heat that has been absorbed. Outlet opening 226 can again be formed, for example, by an opening in the region of the connections of an electrical cable or an electrical device, such as an electrical unit, so that heat can be transported away efficiently from the point of contact between connector 102 and mating connector 104.

Of course, cooling fluid connection 208 and outlet opening 226 can also be attached such that the cooling channel surrounds connector housing 110 upstream and surrounds mating connector housing 112 downstream.

As is shown schematically in Figure 8, electrical connector system 200 comprising connector 102 and mating connector 104 can first be closed for mounting the assembly. Cooling fluid guidance housing 206 can thereafter be made to contact connector housing 110 or mating connector housing 112 (or both) by support elements 230, so that the cooling fluid guidance housing can be attached in a stable manner to electrical connector system 200. Upper shell 218 and lower shell 220 can then be fastened to one another in a closed manner with the aid of fastening elements 222.

Alternatively, cooling fluid guidance housing 206 can also be formed integrally and already be mounted on connector 102 (or mating connector 104) before electrical connector system 200 is closed, so that mating connector 104 (or connector 102) is received in cooling fluid guidance housing 206 when electrical connector system 200 is closed.

In the example of Figure 9, mating connector 104 comprises an electrically conductive pin-shaped contact unit 144 which dips into socket-shaped base body 146 of connector 102. In the plugged-in state, which is presently shown, electrical current can flow via a contact section 148. The heat generated in contact section 148 can be transported away by cooling fluid 114, which, as shown in Figure 9 by arrows, flows around an outer wall 150 of mating connector housing 112 and an outer wall 140 of connector housing 110. The cooling channel through which the cooling fluid flows is there defined by the inner wall of cooling fluid guidance housing 206 and is guided thereby along outer wall 150 of mating connector housing 112 and an outer wall 140 of connector housing 110. In addition to outlet opening 226, further venting openings can be provided on cooling fluid guidance housing 206, for example, in the region of the connections for an electrical cable or an electrical device on mating connector 104.

Furthermore, all cross-sectional diameters or cross-sectional dimensions of the cooling channel are to be selected such that the respective sections of the cooling channel (branches, throttling points, etc.) can have cooling fluid 114 flow therethrough as desired. In particular, the distance between the inner wall of cooling fluid guidance housing 206 and the outer wall of connector housing 110 or mating connector housing 112 is to be selected such that flow rates realizable in the respective sections with acceptable fluid pressures and fluid temperatures not to be exceeded, realizable flow resistances and a realizable cooling volume for the cooling fluid flowing around electrical connector system 200 prevail.

### List of reference characters:

- 100, 200: electrical connector system
- 102: connector
- 104: mating connector
- 106, 206: cooling fluid guidance housing
- 108, 208: cooling fluid connection
- 110: connector housing
- 112: mating connector housing
- 114: cooling fluid
- 116: contact element reception chamber
- 118, 218: upper shell
- 120, 220: lower shell
- 122: fastening elements
- 124: recess
- 126: outlet opening
- 128: outer edge
- 130: support element
- 132: connector module
- 133: holding element
- 134: connecting element
- 136: inlet opening
- 138: cooling fluid guidance wall
- 140: outer wall of the connector housing
- 144: pin-shaped contact unit
- 146: socket-shaped base body
- 148: contact section
- 150: outer wall of the mating connector housing
- 242: receiving section (third section)

## Claims

1. Cooling fluid guidance housing (106) for guiding a cooling fluid (114) around an electrical connector system (100), comprising a connector (102) and a mating connector (104), said cooling fluid guidance housing (106) comprising:
a first section in which at least one support element (130) is arranged with which said cooling fluid guidance housing (106), in operation, contacts a connector housing (110) of said connector (102),
and a second section in which an inner wall of said cooling fluid guidance housing (106) is adapted such that the inner wall of said cooling fluid guidance housing (106) follows an outer wall (140) of said connector housing (110) at a predefined distance after reception of said connector (102),
wherein said inner wall of said cooling fluid guidance housing in said second section defines at least one cooling channel which surrounds at least in part said outer wall (140) of said connector housing (110), and
wherein said cooling fluid guidance housing (106) comprises at least one cooling fluid connection (108) by way of which said cooling fluid (114), in operation, is introduced into said at least one cooling channel,
**characterized in that**
said cooling fluid guidance housing (106) comprises at least one cooling fluid guidance wall (138) which is adapted to define part of said at least one cooling channel and to guide said cooling fluid (114), in operation, along the outer wall (140) of said connector housing (110); and
said cooling fluid guidance housing (106) comprises a plurality of cooling shells (118, 120),
wherein each of said cooling shells (118, 120) comprises fastening elements (122) with the aid of which each cooling shell (118, 120), in operation, is fastened to at least one of the other cooling shells in order to attach, in operation, said cooling fluid guidance housing (106) to the electrical connector system (100).

2. Cooling fluid guidance housing (106) according to one of the preceding claims, wherein said cooling fluid connection (108) is configured as a connection port, a connection flange, or a connection socket.

3. Cooling fluid guidance housing (106) according to one of the preceding claims, wherein said cooling channel, starting out from said cooling fluid connection (108) in said cooling fluid guidance housing (106), opens outwardly along said outer wall (140) of said connector housing (110) through a channel opening for the exit of cooling fluid, where said cooling channel, apart from said channel opening (136), is configured to be permeable to gas at at least one further point along said inner wall of said cooling fluid guidance housing (106).

4. Electrical connector system (100) comprising a connector (102) and a mating connector (104) with a cooling fluid guidance housing (106) according to one of the preceding claims.

5. Electrical connector system (100) according to claim 4, wherein said at least one cooling channel is led along said outer wall (140) of said connector housing (110) such that said at least one cooling channel, in operation, is led in the direction of a heat source within said connector housing (110).

6. Electrical connector system (100) according to one of the claims 4 or 5, wherein said cooling fluid guidance housing (106) comprises at least one second cooling fluid connection (108) for transporting said cooling fluid away downstream.

7. Electrical connector system (100) according to one of the claims 4 to 6, wherein the predefined distance in said second section between said inner wall of said cooling fluid guidance housing (106) and said outer wall of said connector housing (110) differs in an inlet section from that of an outlet section of said at least one cooling channel.

8. Electrical connector system (100) according to one of the claims 4 to 7, wherein said cooling fluid guidance housing (106) in the direction of a contact element access (116) for said mating connector (104) terminates flush with said outer wall (140) of said connector housing (110).

9. Electrical connector system (100) according to one of the claims 4 to 7, wherein said cooling fluid guidance housing (106) is further adapted to receive said mating connector (104), and
wherein said cooling fluid guidance housing (106) comprises a third section in which said inner wall of said cooling fluid guidance housing (106) is adapted such that the inner wall in said third section follows an outer wall (150) of a mating connector housing (112) of said mating connector (104) at a predefined distance, where said inner wall of said cooling fluid guidance housing (106) in said third section defines the at least one cooling channel which surrounds at least in part said outer wall (150) of said mating connector housing (112).

10. Electrical connector system (100) according to one of the claims 4 to 9, wherein said cooling fluid guidance housing (106) is configured such that said inner wall of said cooling fluid guidance housing in said second section with said outer wall (140) of said connector housing (110) each form a plurality of separate cooling channels.

11. Electrical connector system according to one of the claims 4 to 10, wherein said outer wall (140) of said connector (110) comprises at least one fluid guidance element that defines said at least one cooling channel.

12. Method for installing an electrical connector system (110) with a cooling fluid guidance housing (106) for guiding a cooling fluid (114) around said electrical connector system (100), said method comprising the following steps:
providing said electrical connector system (100) comprising a connector (102) and a mating connector (104),
attaching said cooling fluid guidance housing (106), wherein
said cooling fluid guidance housing (106) in a first section in which at least one support element (130) is arranged is made to contact a connector housing (110) of said connector (102),
an inner wall of said cooling fluid guidance housing (106) in a second section follows an outer wall (140) of said connector housing (110) at a predefined distance, where said inner wall of said cooling fluid guidance housing (106) in said second section defines at least one cooling channel which surrounds at least in part said outer wall (140) of said connector housing (110), and
wherein said cooling fluid guidance housing (106) comprises at least one cooling fluid connection (108) by way of which said cooling fluid (114), in operation, is introduced into said at least one cooling channel,
**characterized in that**
said cooling fluid guidance housing (106) comprises at least one cooling fluid guidance wall (138) which is adapted to define part of said at least one cooling channel and to guide said cooling fluid (114) along the outer wall (140) of said connector housing (110), and
said cooling fluid guidance housing (106) comprises a plurality of cooling shells (118, 120), wherein each of said cooling shells (118, 120) comprises fastening elements (122) with the aid of which each cooling shell (118, 120) is fastened to at least one of the other cooling shells in order to attach, in operation, said cooling fluid guidance housing (106) to the electrical connector system (100).

13. Method according to claim 12, wherein said the cooling fluid guidance housing (106) is attached in such a manner that said inner wall of said cooling fluid guidance housing (106) in a third section follows an outer wall (150) of a mating connector housing (112) of said mating connector (104) at a predefined distance, wherein said inner wall of said cooling fluid guidance housing (106) in said third section defines the at least one cooling channel which surrounds at least in part said outer wall (150) of said mating connector housing (112).

## Patentansprüche

1. Kühlfluidleitgehäuse (106) zum Leiten eines Kühlfluids (114) um ein elektrisches Verbindersystem (100), umfassend einen Steckverbinder (102) und einen Gegensteckverbinder (104), wobei das Kühlfluidleitgehäuse (106) umfasst:
einen ersten Bereich, in dem mindestens ein Abstützelement (130) angeordnet ist, durch das das Kühlfluidleitgehäuse (106), im Betrieb, mit einem Steckverbindergehäuse (110) des Steckverbinders (102) in Kontakt gebracht werden kann,
und einen zweiten Bereich, in dem eine innere Wandung des Kühlfluidleitgehäuses (106) so angepasst ist, dass die innere Wandung des Kühlfluidleitgehäuses (106) einer äußeren Wandung (140) des Steckverbindergehäuses (110) nach Aufnahme des Steckverbinders (102) in einem vordefinierten Abstand folgt,
wobei in dem zweiten Bereich die innere Wandung des Kühlfluidleitgehäuses mindestens einen Kühlkanal begrenzt, der die äußere Wandung (140) des Steckverbindergehäuses (110) wenigstens teilweise umgibt, und
wobei das Kühlfluidleitgehäuse (106) mindestens einen Kühlfluidanschluss (108) aufweist, mittels welchem das Kühlfluid (114) in den mindestens einen Kühlkanal einleitbar ist,
**dadurch gekennzeichnet, dass**
das Kühlfluidleitgehäuse (106) mindestens eine Kühlfluidleitwand (138) umfasst, die dazu angepasst ist, einen Teil des mindestens einen Kühlkanals zu begrenzen und das Kühlfluid (114), im Betrieb, entlang der äußeren Wandung (140) des Steckverbindergehäuses (110) zu leiten, und
das Kühlfluidleitgehäuse (106) eine Vielzahl von Kühlschalen (118, 120) umfasst, wobei jede der Kühlschalen (118, 120) Befestigungselemente (122) aufweist, mit deren Hilfe jede Kühlschale (118, 120), im Betrieb, an mindestens einer der anderen Kühlschalen (118, 120) befestigt werden kann, um, im Betrieb, das Kühlfluidleitgehäuse (106) an dem Verbindersystem (100) anzubringen.

2. Kühlfluidleitgehäuse (106) nach einem der vorherigen Ansprüche, wobei der Kühlfluidanschluss (108) als ein Anschlussstutzen, ein Anschlussflansch oder eine Anschlussbuchse ausgebildet ist.

3. Kühlfluidleitgehäuse (106) nach einem der vorherigen Ansprüche, wobei sich der Kühlkanal, ausgehend vom Kühlfluidanschluss (108) im Kühlfluidleitgehäuse (106) nach außen entlang der äußeren Wandung (140) des Steckverbindergehäuses (110) durch eine Kanalöffnung (136) zum Austritt von Kühlfluid öffnet, wobei der Kühlkanal, abgesehen von der Kanalöffnung (136), an wenigstens einer weiteren Stelle entlang der inneren Wandung des Kühlfluidleitgehäuses (106) gasdurchlässig ausgebildet ist.

4. Elektrisches Verbindersystem (100), umfassend einen Steckverbinder (102) und einen Gegensteckverbinder (104), mit einem Kühlfluidleitgehäuse (106) nach einem der vorhergehenden Ansprüche.

5. Elektrisches Verbindersystem (100) nach Anspruch 4, wobei der mindestens eine Kühlkanal entlang der äußeren Wandung (140) des Steckverbindergehäuses (110) so geführt ist, dass der mindestens eine Kühlkanal, im Betrieb, in Richtung einer Wärmequelle innerhalb des Steckverbindergehäuses (110) hinführbar ist.

6. Elektrisches Verbindersystem (100) nach einem der Ansprüche 4 oder 5, wobei das Kühlfluidleitgehäuse (106) mindestens einen zweiten Kühlfluidanschluss (108) für einen stromabwärtigen Abtransport des Kühlfluids aufweist.

7. Elektrisches Verbindersystem (100) nach einem der Ansprüche 4 bis 6, wobei sich in dem zweiten Bereich der vordefinierte Abstand zwischen der inneren Wandung des Kühlfluidleitgehäuses (106) und der äußeren Wandung (140) des Steckverbindergehäuses (110) in einem Eingangsbereich von dem eines Ausgangsbereichs des mindestens einen Kühlkanals unterscheidet.

8. Elektrisches Verbindersystem (100) nach einem der Ansprüche 4 bis 7, wobei das Kühlfluidleitgehäuse (106) in Richtung eines Kontaktelementzugangs (116) für den Gegensteckverbinder (104) bündig mit der äußeren Wandung (140) des Steckverbindergehäuses (110) abschließt.

9. Elektrisches Verbindersystem (100) nach einem der Ansprüche 4 bis 7, wobei das Kühlfluidleitgehäuse (106) weiterhin dazu angepasst ist, den Gegensteckverbinder (104) aufzunehmen, und
wobei das Kühlfluidleitgehäuse (106) einen dritten Bereich umfasst, in dem die innere Wandung des Kühlfluidleitgehäuses (106) so angepasst ist, dass die innere Wandung in dem dritten Bereich einer äußeren Wandung (150) eines Gegensteckverbindergehäuses (112) des Gegensteckverbinders (104) in einem vordefinierten Abstand folgt, wobei in dem dritten Bereich die innere Wandung des Kühlfluidleitgehäuses (106) den mindestens einen Kühlkanal begrenzt, der die äußere Wandung (150) des Gegensteckverbindergehäuses (112) wenigstens teilweise umgibt.

10. Elektrisches Verbindersystem (100) nach einem der Ansprüche 4 bis 9, wobei das Kühlfluidleitgehäuse (106) so eingerichtet ist, dass in dem zweiten Bereich die innere Wandung des Kühlfluidleitgehäuses mit der äußeren Wandung (140) des Steckverbindergehäuses (110) jeweils eine Vielzahl von separaten Kühlkanälen bildet.

11. Elektrisches Verbindersystem nach einem der Ansprüche 4 bis 10, wobei die äußere Wandung (140) des Steckverbinders (110) mindestens ein Fluidleitelement umfasst, dass den mindestens einen Kühlkanal begrenzt.

12. Verfahren zum Einbau eines elektrischen Verbindersystems (100) mit einem Kühlfluidleitgehäuse (106) zum Leiten eines Kühlfluids (114) um das elektrische Verbindersystem (100), wobei das Verfahren die folgenden Schritte aufweist:
Bereitstellen des elektrischen Verbindersystems (100), umfassend einen Steckverbinder (102) und einen Gegensteckverbinder (104),
Anbringen des Kühlfluidleitgehäuses (106), wobei
das Kühlfluidleitgehäuse (106) in einem ersten Bereich, in dem mindestens ein Abstützelement (130) angeordnet ist, mit einem Steckverbindergehäuse (110) des Steckverbinders (102) in Kontakt gebracht wird,
eine innere Wandung des Kühlfluidleitgehäuses (106) in einem zweiten Bereich einer äußeren Wandung (140) des Steckverbindergehäuses (110) in einem vordefinierten Abstand folgt, wobei in dem zweiten Bereich die innere Wandung des Kühlfluidleitgehäuses (106) mindestens einen Kühlkanal begrenzt, der die äußere Wandung (140) des Steckverbindergehäuses (110) wenigstens teilweise umgibt, und
das Kühlfluidleitgehäuse (106) mindestens einen äußeren Kühlfluidanschluss (108) aufweist, mittels welchem das Kühlfluid (114), im Betrieb, in den mindestens einen Kühlkanal einleitbar ist,
**dadurch gekennzeichnet, dass**
das Kühlfluidleitgehäuse (106) mindestens eine Kühlfluidleitwand (138) umfasst, die dazu angepasst ist, einen Teil des mindestens einen Kühlkanals zu begrenzen und das Kühlfluid (114) entlang der äußeren Wandung (140) des Steckverbindergehäuses (110) zu leiten, und
das Kühlfluidleitgehäuse (106) eine Vielzahl von Kühlschalen (118, 120) umfasst, wobei jede der Kühlschalen (118, 120) Befestigungselemente (122) aufweist, mit deren Hilfe jede Kühlschale (118, 120) an mindestens einer der anderen Kühlschalen (118, 120) befestigt werden kann, um, im Betrieb, das Kühlfluidleitgehäuse (106) an dem Verbindersystem (100) anzubringen.

13. Verfahren nach Anspruch 12, wobei das Kühlfluidleitgehäuse (106) solcher Art angebracht wird, dass die innere Wandung des Kühlfluidleitgehäuses (106) in einem dritten Bereich einer äußeren Wandung (150) eines Gegensteckverbindergehäuses (112) des Gegensteckverbinders (104) in einem vordefinierten Abstand folgt, wobei in dem dritten Bereich die innere Wandung des Kühlfluidleitgehäuses (106) den mindestens einen Kühlkanal begrenzt, der die äußere Wandung (150) des Gegensteckverbindergehäuses (112) wenigstens teilweise umgibt.

## Revendications

1. Boîtier de guidage de fluide de refroidissement (106) pour guider un fluide de refroidissement (114) autour d'un système de connecteurs électriques (100), comprenant un connecteur (102) et un connecteur d'accouplement (104), ledit boîtier de guidage de fluide de refroidissement (106) comprenant :
une première section dans laquelle est agencé au moins un élément de support (130) avec lequel ledit boîtier de guidage de fluide de refroidissement (106), en fonctionnement, entre en contact avec un boîtier de connecteur (110) dudit connecteur (102),
et une deuxième section dans laquelle une paroi intérieure dudit boîtier de guidage de fluide de refroidissement (106) est adaptée de telle sorte que la paroi intérieure dudit boîtier de guidage de fluide de refroidissement (106) suit une paroi extérieure (140) dudit boîtier de connecteur (110) à une distance prédéfinie après réception dudit connecteur (102),
dans lequel ladite paroi intérieure dudit boîtier de guidage de fluide de refroidissement dans ladite deuxième section définit au moins un canal de refroidissement qui entoure au moins en partie ladite paroi extérieure (140) dudit boîtier de connecteur (110), et
dans lequel ledit boîtier de guidage de fluide de refroidissement (106) comprend au moins un raccord de fluide de refroidissement (108) à l'aide duquel ledit fluide de refroidissement (114), en fonctionnement, est introduit dans ledit au moins un canal de refroidissement,
**caractérisé en ce que**
ledit boîtier de guidage de fluide de refroidissement (106) comprend au moins une paroi de guidage de fluide de refroidissement (138) qui est adaptée pour définir une partie dudit au moins un canal de refroidissement et pour guider ledit fluide de refroidissement (114), en fonctionnement, le long de la paroi extérieure (140) dudit boîtier de connecteur (110) ; et
ledit boîtier de guidage de fluide de refroidissement (106) comprend une pluralité de coques de refroidissement (118, 120), dans lequel chacune desdites coques de refroidissement (118, 120) comprend des éléments de fixation (122) à l'aide desquels chaque coque de refroidissement (118, 120), en fonctionnement, est fixée à au moins l'une des autres coques de refroidissement afin de fixer, en fonctionnement, ledit boîtier de guidage de fluide de refroidissement (106) au système de connecteurs électriques (100).

2. Boîtier de guidage de fluide de refroidissement (106) selon l'une des revendications précédentes, dans lequel ledit raccord de fluide de refroidissement (108) est configuré sous forme d'un port de raccordement, d'une bride de raccordement, ou d'une fiche de raccordement.

3. Boîtier de guidage de fluide de refroidissement (106) selon l'une des revendications précédentes, dans lequel ledit canal de refroidissement, partant dudit raccord de fluide de refroidissement (108) dans ledit boîtier de guidage de fluide de refroidissement (106), s'ouvre vers l'extérieur le long de ladite paroi extérieure (140) dudit boîtier de connecteur (110) à travers une ouverture de canal destinée à la sortie de fluide de refroidissement, où ledit canal de refroidissement, à l'exception de ladite ouverture de canal (136), est configuré pour être perméable au gaz au niveau d'au moins un point supplémentaire le long de ladite paroi intérieure dudit boîtier de guidage de fluide de refroidissement (106).

4. Système de connecteurs électriques (100) comprenant un connecteur (102) et un connecteur d'accouplement (104) avec un boîtier de guidage de fluide de refroidissement (106) selon l'une des revendications précédentes.

5. Système de connecteurs électriques (100) selon la revendication 4, dans lequel ledit au moins un canal de refroidissement est dirigé le long de ladite paroi extérieure (140) dudit boîtier de connecteur (110) de telle sorte que ledit au moins un canal de refroidissement, en fonctionnement, est dirigé dans la direction d'une source de chaleur à l'intérieur dudit boîtier de connecteur (110).

6. Système de connecteurs électriques (100) selon l'une des revendications 4 ou 5, dans lequel ledit boîtier de guidage de fluide de refroidissement (106) comprend au moins un second raccord de fluide de refroidissement (108) pour transporter ledit fluide de refroidissement vers aval.

7. Système de connecteurs électriques (100) selon l'une des revendications 4 à 6, dans lequel la distance prédéfinie dans ladite deuxième section entre ladite paroi intérieure dudit boîtier de guidage de fluide de refroidissement (106) et ladite paroi extérieure dudit boîtier de connecteur (110) diffère dans une section d'entrée de celle d'une section de sortie dudit au moins un canal de refroidissement.

8. Système de connecteurs électriques (100) selon l'une des revendications 4 à 7, dans lequel ledit boîtier de guidage de fluide de refroidissement (106) dans la direction d'un accès par élément de contact (116) pour ledit connecteur d'accouplement (104) se termine à fleur de ladite paroi extérieure (140) dudit boîtier de connecteur (110).

9. Système de connecteurs électriques (100) selon l'une des revendications 4 à 7, dans lequel ledit boîtier de guidage de fluide de refroidissement (106) est en outre adapté pour recevoir ledit connecteur d'accouplement (104), et
dans lequel ledit boîtier de guidage de fluide de refroidissement (106) comprend une troisième section dans laquelle ladite paroi intérieure dudit boîtier de guidage de fluide de refroidissement (106) est adaptée de telle sorte que la paroi intérieure dans ladite troisième section suit une paroi extérieure (150) d'un boîtier de connecteur d'accouplement (112) dudit connecteur d'accouplement (104) à une distance prédéfinie, où ladite paroi intérieure dudit boîtier de guidage de fluide de refroidissement (106) dans ladite troisième section définit ledit au moins un canal de refroidissement qui entoure au moins en partie ladite paroi extérieure (150) dudit boîtier de connecteur d'accouplement (112).

10. Système de connecteurs électriques (100) selon l'une des revendications 4 à 9, dans lequel ledit boîtier de guidage de fluide de refroidissement (106) est configuré de telle sorte que ladite paroi intérieure dudit boîtier de guidage de fluide de refroidissement dans ladite deuxième section avec ladite paroi extérieure (140) dudit boîtier de connecteur (110) forment chacune une pluralité de canaux de refroidissement séparés.

11. Système de connecteurs électriques selon l'une des revendications 4 à 10, dans lequel ladite paroi extérieure (140) dudit connecteur (110) comprend au moins un élément de guidage de fluide qui définit ledit au moins un canal de refroidissement.

12. Procédé d'installation d'un système de connecteurs électriques (110) avec un boîtier de guidage de fluide de refroidissement (106) pour guider un fluide de refroidissement (114) autour dudit système de connecteurs électriques (100), ledit procédé comprenant les étapes suivantes consistant à :
fournir ledit système de connecteurs électriques (100) comprenant un connecteur (102) et un connecteur d'accouplement (104),
fixer ledit boîtier de guidage de fluide de refroidissement (106), dans lequel
ledit boîtier de guidage de fluide de refroidissement (106) dans une première section dans laquelle est agencé au moins un élément de support (130) est amené en contact avec un boîtier de connecteur (110) dudit connecteur (102),
une paroi intérieure dudit boîtier de guidage de fluide de refroidissement (106) dans une deuxième section suit une paroi extérieure (140) dudit boîtier de connecteur (110) à une distance prédéfinie, où ladite paroi intérieure dudit boîtier de guidage de fluide de refroidissement (106) dans ladite deuxième section définit au moins un canal de refroidissement qui entoure au moins en partie ladite paroi extérieure (140) dudit boîtier de connecteur (110), et
dans lequel ledit boîtier de guidage de fluide de refroidissement (106) comprend au moins un raccord de fluide de refroidissement (108) à l'aide duquel ledit fluide de refroidissement (114), en fonctionnement, est introduit dans ledit au moins un canal de refroidissement,
**caractérisé en ce que**
ledit boîtier de guidage de fluide de refroidissement (106) comprend au moins une paroi de guidage de fluide de refroidissement (138) qui est adaptée pour définir une partie dudit au moins un canal de refroidissement et pour guider ledit fluide de refroidissement (114) le long de la paroi extérieure (140) dudit boîtier de connecteur (110), et
ledit boîtier de guidage de fluide de refroidissement (106) comprend une pluralité de coques de refroidissement (118, 120), dans lequel chacune desdites coques de refroidissement (118, 120) comprend des éléments de fixation (122) à l'aide desquels chaque coque de refroidissement (118, 120) est fixée à au moins l'une des autres coques de refroidissement afin de fixer, en fonctionnement, ledit boîtier de guidage de fluide de refroidissement (106) au système de connecteurs électriques (100).

13. Procédé selon la revendication 12, dans lequel ledit boîtier de guidage de fluide de refroidissement (106) est fixé de telle sorte que ladite paroi intérieure dudit boîtier de guidage de fluide de refroidissement (106) dans une troisième section suit une paroi extérieure (150) d'un boîtier de connecteur d'accouplement (112) dudit connecteur d'accouplement (104) à une distance prédéfinie, dans lequel ladite paroi intérieure dudit boîtier de guidage de fluide de refroidissement (106) dans ladite troisième section définit ledit au moins un canal de refroidissement qui entoure au moins en partie ladite paroi extérieure (150) dudit boîtier de connecteur d'accouplement (112).
